# EUROPÄISCHE PATENTSCHRIFT

(11) **EP 1 863 948 B1**
(45) Veröffentlichungstag und Bekanntmachung des Hinweises auf die Patenterteilung: **09.03.2011**
(21) Anmeldenummer: 05738478.6
(22) Anmeldetag: 31.03.2005
(51) Int. Cl.: C23C 14/56

(54) **VORRICHTUNG UND VERFAHREN FÜR DEN TRANSPORT EINES SCHLAUCHS VON EINER ERSTEN KAMMER IN EINE ZWEITE KAMMER**
DEVICE AND METHOD FOR THE TRANSPORT OF A TUBE FROM A FIRST CHAMBER INTO A SECOND CHAMBER
DISPOSITIF ET PROCEDE POUR TRANSPORTER UN TUYAU D'UNE PREMIERE CHAMBRE VERS UNE SECONDE CHAMBRE

(43) Veröffentlichungstag der Anmeldung: 12.12.2007
(73) Patentinhaber: Applied Materials GmbH & Co. KG, 63755 Alzenau (DE)
(72) Erfinder: KAMPMANN, Lutz, 63776 Mömbris (DE); SOMMER, Elisabeth, 63755 Alzenau (DE); MICHAEL, Klaus, 63571 Gelnhausen (DE); GERTMANN, Reiner, 63589 Linsengericht (DE); GRIMM, Helmut, 64291 Darmstadt (DE)
(74) Vertreter: Schickedanz, Willi
(86) Internationale Anmeldenummer: PCT/EP2005/003364
(87) Internationale Veröffentlichungsnummer: WO 2006/102914

(56) Entgegenhaltungen:
- DE-A1- 3 116 026
- DE-A1- 19 927 062

## Beschreibung

Die Erfindung betrifft eine Vorrichtung nach dem Oberbegriff des Patentanspruchs 1 und ein Verfahren nach den Patentansprüchen 16 oder 17.

Verschiedenste Arten an Formkörpen, wie beispielsweise Schläuche und Rohre, sind zum Einsatz im Hinblick auf den Transport von flüssigen oder gasförmigen Medien bekannt. Übliche Einsatzbereiche derartiger Formkörper sind Kraftstoffleitungsanlagen in Kraftfahrzeugen oder industrielle Rohrleitungssysteme, die Grundstoffe oder Prozessgase, wie Alkohole, Heißdampf usw. transportieren. Üblicherweise wird ein Formkörper in Schlauchform oder Rohrform eingesetzt, der als Grundkörper eine Plastikschicht aufweist, beispielsweise geformt aus üblichen Kunststoffen, wie Polyolefinen, Polyamiden oder ähnlichen Substanzen. Diese Plastikschicht bestimmt im Wesentlichen Form und Eigenschaften eines Formkörpers.

Allerdings weisen derartige Plastik-Schichten häufig nur eine unzureichende Barriereeigenschaft gegenüber den zu transportierenden Stoffen auf, sodass die Gefahr besteht, dass gegebenenfalls umweltschädliche Substanzen durch die Rohr- bzw. Schlauchwandungen treten. Hierdurch ist die Gefahr des Verlusts an transportiertem Stoff gegeben, was Umweltverschmutzung hervorrufen kann oder die Arbeitsplatzsicherheit bzw. die Funktion von komplexen Systemen beeinträchtigt, die derartige Rohre oder Schläuche umfassen. Alternativ ist es in einigen Fällen aber auch erwünscht, dass eine Permeation von außen in ein Rohr bzw. einen Schlauch verhindert wird. Dies ist insbesondere erwünscht bei Rohr- oder Schlauchleitungen, die unterirdisch verlegt und zum Einsatz im Hinblick auf die Trinkwasserversorgung verwendet werden. Bei derartigen Systemen muss sichergestellt werden, dass gegebenenfalls im Boden vorhandene schädliche Substanzen nicht in das Trinkwasser gelangen, das in der Rohrleitung transportiert wird.

Es ist bereits ein Kunststoffschlauch zum Transport eines Kohlendioxid-Kühlmittels bekannt, der durch eine Mehrzahl von Schichten gekennzeichnet ist, wobei mindestens eine gegenüber Kohlenstoffdioxid undurchlässige metallische Schicht vorgesehen ist, die sich zwischen zwei Kunststoffschichten befindet (EP 1 020 673 A1). Die metallische Schicht wird durch ein Dampfabscheidungsverfahren erzeugt und besteht beispielsweise aus Aluminium. Bei einem anderen bekannten Kunststoffrohr befindet sich die Barriereschicht auf der Außenseite des Kunststoffrohrs und wird durch ein physikalisches Dampfabscheidungsverfahren im Hochvakuum erzeugt (WO 02/01115 A1). Die Dicke dieser Barriereschicht, die beispielsweise Aluminium, eine Aluminiumlegierung oder Aluminiumoxid umfassen kann, beträgt bevorzugt weniger als 1 µm.

Das Anbringen dieser Schichten wird in der Regel in Vakuumanlagen durchgeführt, die aus verschiedenen Bereichen bestehen können, beispielsweise aus einer Schleusenkammer, einer Transferkammer und einer Prozesskammer. In diesen Kammern herrschen verschiedene Gasdrücke. Während in der Schleusenkammer im gefluteten Zustand noch Atmosphärendruck herrscht, der zum Einschleusen der Substrate an den Druck der Transferkammer angeglichen wird, ist in der Transferkammer der Druck erheblich geringer, um dann in der Prozesskammer extrem niedrig zu sein. Das Hochvakuum der Prozesskammer wird etwa durch Diffusionspumpen erzeugt. Transferkammer und Prozesskammer bilden oft eine vakuumtechnische Einheit und werden gemeinsam mittels Hochvakuumpumpen evakuiert.

Wichtig ist hierbei, dass der Übergang von einer Kammer zur nächsten so erfolgen muss, dass möglichst kein Druckausgleich zwischen den Kammern erfolgt.

Es sind bereits Transportsysteme bekannt, mit denen dreidimensionale Gegenstände von einem ersten Bereich zu einem zweiten Bereich transportiert werden können (DE 38 01 061 A1, AT 001 964 U1, US 6 588 989 B2). Diese Transportsysteme sind jedoch nicht für Vakuum-Beschichtungsanlagen geeignet.

Der Erfindung liegt die Aufgabe zugrunde, eine Vorrichtung und ein Verfahren zu schaffen, mit der schlauchförmige Formkörper in einer Vakuumanlage beschichtet werden können.

Diese Aufgabe wird gemäß den Merkmalen der Patentansprüche 1,16 oder 17 gelöst.

Die Erfindung betrifft somit eine Vorrichtung für den Transport eines Schlauchs von einer Abwickeltrommel durch wenigstens eine Bearbeitungskammer sowie ein Verfahren zum Versehen dieses Schlauchs mit einer Barriereschicht. Der Schlauch gelangt hierbei von einer Abwickeltrommel auf den Umfang einer Schleusentrommel, gegen die ein Schleusenrad drückt. Schleusentrommel und Schleusenrad weisen jeweils eine Nut auf, deren Querschnitt vorzugsweise dem halben Querschnitt des Schlauchs entspricht. Über diese Schleusentrommel gelangt der Schlauch über eine Transferkammer in eine Beschichtungskammer, wo er mit einem Polymer beschichtet wird. Danach gelangt er in eine Metallisierungskammer, wo er mit einer Metallschicht versehen wird. Hierauf wird der Schlauch um 180 Grad umgelenkt und noch einmal in der Metallisierungskammer und der Beschichtungskammer beschichtet. Anschließend gelangt der Schlauch über die Schleusentrommel zur Aufwickeltrommel, wo der nunmehr beschichtete Schlauch aufgewickelt wird.

Der mit der Erfindung erzielte Vorteil besteht insbesondere darin, dass schlauchförmige Formkörper zwischen Kammern von unterschiedlichem Druck bewegt werden können.

Ein Ausführungsbeispiel der Erfindung ist in den Zeichnungen dargestellt und wird im Folgenden näher beschrieben. Es zeigen:
Fig. 1 eine Anlage zum Beschichten eines Schlauchs;
Fig. 2 eine perspektivische Darstellung einer Schleusenkammer;
Fig. 3 eine Draufsicht auf die Schleusenkammer der Fig. 2;
Fig. 4 einen Schnitt durch Schleusenrollen;
Fig. 5 einen Schnitt durch eine Schleusenrolle mit Dichtlippe;
Fig. 6 einen Schnitt durch eine Trennwand mit einer Öffnung zum Durchschieben eines Schlauchs;
Fig. 7 eine vergrößerte und perspektivische Ansicht einer Schleusentrommel mit mehreren Schleusenrädern.

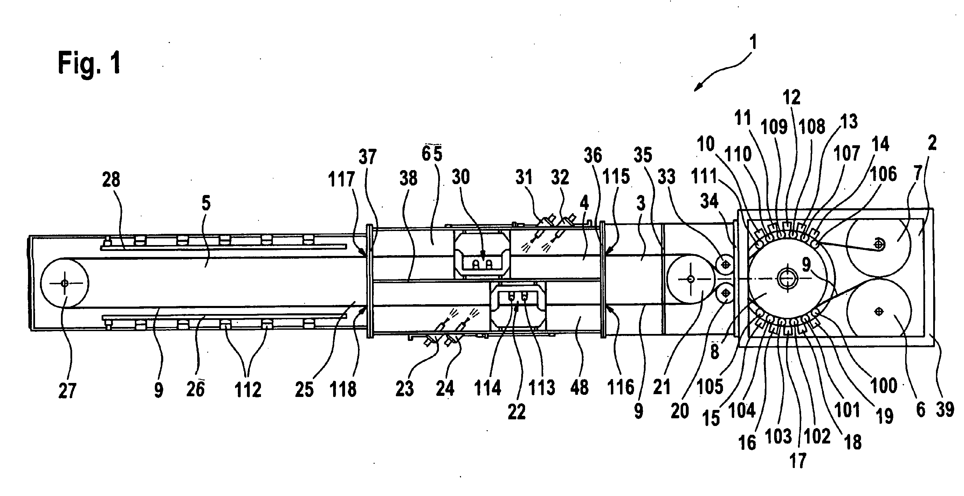

Die Fig. 1 zeigt eine Schlauchbeschichtungsanlage 1, die aus mehreren Bereichen besteht. An eine Eingangskammer 2 schließt eine Transferkammer 3 an, auf die eine Beschichtungskammer 4 folgt. Den Abschluss bildet eine Metallisierungskammer 5.

In der Eingangskammer 2 sind eine Abwickeltrommel 6, eine Aufwickeltrommel 7 und eine Schleusentrommel 8 vorgesehen. Ein zu beschichtender Schlauch 9 wird von der Abwickeltrommel 6 abgewickelt und auf die Schleusentrommel 8 gegeben. Auf dem Umfang der Schleusentrommel 8 befinden sich mehrere Schleusenräder 100 bis 105 bzw. 106 bis 111. Diese Schleusenräder sind von einer Kammerwand 39 umgeben. Außerdem sind mehrere Pumpstutzen 10 bis 14 bzw. 15 bis 19 vorgesehen, die mit nicht dargestellten Pumpen verbunden sind, welche die durch einen Spalt zwischen Schlauch 9 und Schleusentrommel 8 einströmende Luft absaugen. Es werden also die Zwischenräume zwischen den einzelnen Schleusenrädern 100 bis 105, 106 bis 111 abgepumpt. Nähere Einzelheiten über den Aufbau einer Schleuse mit einer Schleusentrommel 8 sind in der DE 198 07 031 A1 beschrieben. In der DE 10 2004 012 663.1 sind zwei hintereinander angeordnete Schleusen beschrieben.

Der Schlauch 9 gelangt hierauf durch eine Öffnung in einer Wand 34 in die Transferkammer 3, wo er durch Umlenktrommeln 20,21 so ausgerichtet wird, dass der hinlaufende Teil des Schlauchs 9 parallel zum rücklaufenden Teil des Schlauchs verläuft. In der durch nicht dargestellte Pumpen evakuierbaren Transferkammer 3 wird der Druck auf Prozesskammerniveau heruntergepumpt, wobei auch die durch die Spalten zwischen Schleusentrommel 8 und Schleusenrad trotz Abpumpen dennoch hereinströmende Luft abgesaugt wird.

Von der Transferkammer 3 gelangt der Schlauch 9 durch eine Öffnung 116 in einer Trennwand 36 in eine Vorlauf-Beschichtungskammer 48 der Beschichtungskammer 4, die durch eine quer verlaufende Trennwand 38 von einer Rücklauf-Beschichtungskammer 65 getrennt ist.

In dieser Vorlauf-Beschichtungskammer 48 befindet sich eine Beschichtungsvorrichtung 22, mit der auf den Schlauch 9 eine Monomerschicht aufgetragen wird. Hierzu wird- was in der Fig. 1 im Einzelnen nicht dargestellt ist - ein flüssiges Monomer oder Monomergemisch aus einem Vorratsbehälter durch einen Schlauch über eine Düse in einen beheizten Kessel in Form von sehr kleinen Tropfen eingespritzt. Da der Vorratsbehälter unter Atmosphärendruck steht und der Kessel mit dem Vakuumsystem verbunden ist, wird das flüssige Monomer durch diese Druckdifferenz gefördert. Beim Auftreffen dieser Tropfen auf die heiße Kesselwand findet eine augenblickliche Verdampfung des Monomers bzw. der Monomermischung statt. Über ebenfalls nicht dargestellte beheizte Rohre wird der Monomerdampf in die Beschichtungskammer 4 zu einer oder mehreren Verdampfungsdüsen 113, 114 geleitet. Der aus diesen Verdampfungsdüsen 113, 114 austretende Monomerdampf wird auf die zu bedampfende Oberfläche des Schlauchs 9 gerichtet, um dort zu kondensieren. Mit Hilfe von Elektronenstrahlkanonen 23, 24 wird die Monomerschicht ausgehärtet und zu einer ersten Polymerschicht vernetzt.

Die Beschichtungskainmer 4 wird dabei durch einen geheizten Kasten, der das gesamte örtliche Bedampfungsvolumen umgibt, abgeschirmt und gegen Verschmutzung geschützt. Durch zwei Öffnungen 115, 116 in der Wand 36 wird der Schlauch 9 aus der Transferkammer 3 in dieses Bedampfungsvolumen hinein und anschließend wieder durch zwei weitere Öffnungen 117, 118 in der Trennwand 37 herausgeführt.

Nachdem der Schlauch 9 in der Vorlauf-Beschichtungskammer 48 mit einem Monomer versehen wurde, das anschließend durch die Elektronen der Elektronenstrahlkanonen 23, 24 zu einer Polymerschicht vernetzt wird, gelangt der Schlauch 9 durch eine Öffnung 118 in der Trennwand 37 in die Metallisierungskammer 5. Diese Metallisierungskammer 5 kann durch eine quer verlaufende und nicht dargestellte Trennwand, die der Trennwand 38 der Beschichtungskammer 4 entspricht, in zwei Hälften unterteilt sein.

In der Vorlauf-Hälfte der Metallisierungskammer 5 befindet sich eine Sputterstation 25 mit einer Planarkathode 26 und mehreren Halterungen 112 für diese Planarkathode 26. Der Schlauch 9 wird hierbei mittels eines Sputterprozesses mit einer Metall-, Metalloxid- oder Metallnitridschicht versehen. Es kann jedoch statt einer Planarkathode eine Kathode mit rohrförmigem Target verwendet werden, wobei das Target von der Innenfläche des Rohrs abgeschieden wird.

Nachdem der Schlauch 9 metallisiert ist, gelangt er über eine Umlenkrolle 27 in eine Rücklauf-Metallisierungskammer, wo sich eine weitere Sputterstation mit einer Sputter-Planarkathode 28 befindet. Dort kann der Schlauch 9 mit einer weiteren Metall-, Metalloxid- oder Metallnitridschicht versehen werden.

Hierauf gelangt der Schlauch 9 durch eine Öffnung 117 in der Trennwand 37 in die Rücklauf-Beschichtungskammer 65, wo er mittels einer Beschichtungsvorrichtung 30 mit einer zweiten Monomerschicht versehen wird. Diese zweite Monomerschicht wird mittels Elektronenstrahlkanonen 31, 33 ausgehärtet und zu einem Polymer versetzt.

Über eine Öffnung 115 in der Trennwand 36 gelangt der beschichtete Schlauch 9 wieder in die Transferkammer 3, wo er über die Umlenkrollen 21, 33 umgelenkt und in die Eingangskammer 2 eingefahren wird.

Es versteht sich, dass der Schlauch 9 bei seinem Transport durch die Beschichtungskammern nicht in jeder Kammer beschichtet werden muss. Es können eine, zwei oder drei der Beschichtungseinrichtungen 22, 30, 26, 28 ausgeschaltet bleiben.

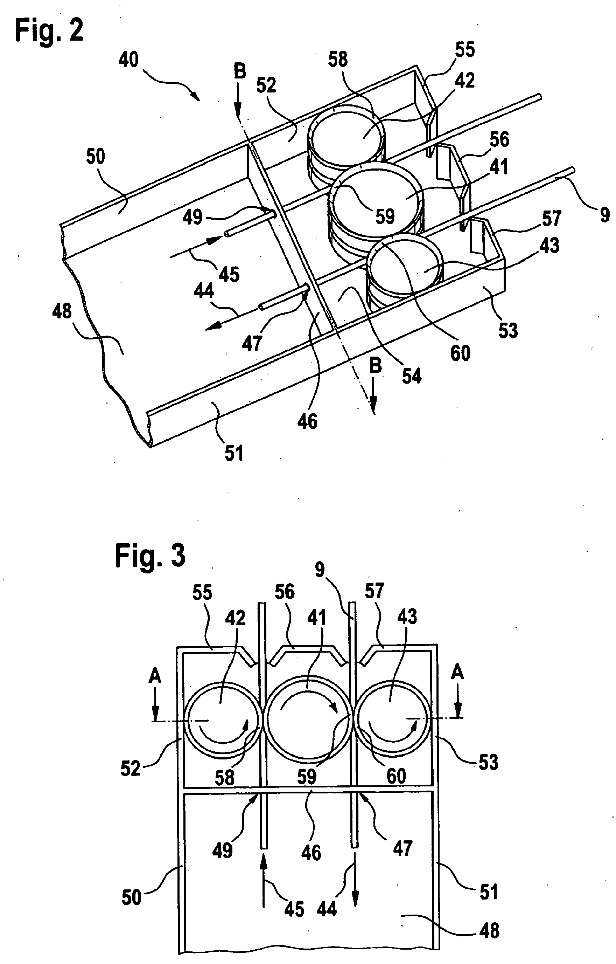

In der Fig. 2 ist schematisch eine Vorrichtung 40 dargestellt, über die der Schlauch 9 von einer Kammer in die nächste Kammer eingeschleust wird. Bei dieser Vorrichtung 40 handelt es sich um eine Variante der in der Fig. 1 gezeigten Anordnung der Schleusentrommel und der Schleusenräder. Anders als in Fig. 1 sind hierbei nur zwei Schleusenräder 42, 43 vorgesehen. Man erkennt eine mittlere Schleusentrommel 41, ein erstes äußeres Schleusenrad 42 und ein zweites äußeres Schleusenrad 43. Der Schlauch 9 wird zwischen der Schleusentrommel 41 und dem Schleusenrad 43 in einer ersten Richtung und zwischen der Schleusentrommel 41 und dem Schleusenrad 42 in einer zweiten Richtung geführt, was durch die Pfeile 44 bzw. 45 angezeigt ist. Er gelangt über eine Trennwand 46, die mit einer Bohrung 47 versehen ist, in eine Transferkammer 48 und von dort in eine nicht dargestellte weitere Kammer. Nachdem der Schlauch 9 in verschiedenen Kammern beschichtet worden ist, gelangt er über eine zweite Öffnung 49 in der Trennwand 46 zu dem Schleusenrad 42 und der Schleusentrommel 41. Die Trennwand 46 ist zwischen den Wänden 50, 51 der Transferkammer 48 angeordnet. An diese Wände schließen sich die Wände 52, 53 der Schleusenkammer 54 an.

Die Schleusenräder 42, 43 und die Schleusentrommel 41 sind mit Wänden 55, 56, 57 abgedeckt und weisen auf ihrer Oberseite im Querschnitt keilförmige Dichtungen 58, 59, 60 auf. Die auf der Unterseite vorgesehenen keilförmigen Dichtungen sind in der Fig. 2 nicht zu erkennen.

In der Fig. 3 ist die Vorrichtung 40 der Fig. 2 noch einmal in einer Draufsicht dargestellt. Man erkennt hierbei, dass sich die beiden äußeren Schleusenräder 42, 43 im Gegenuhrzeigersinn bewegen, während sich die mittlere Schleusentrommel 41 im Uhrzeigersinn bewegt. Hierdurch wird der Schlauch in Richtung des Pfeils 44 zur Kammer 48 und in Richtung des Pfeils 45 von der Kammer 48 weg und auf die Schleusenkammer 54 zu bewegt.

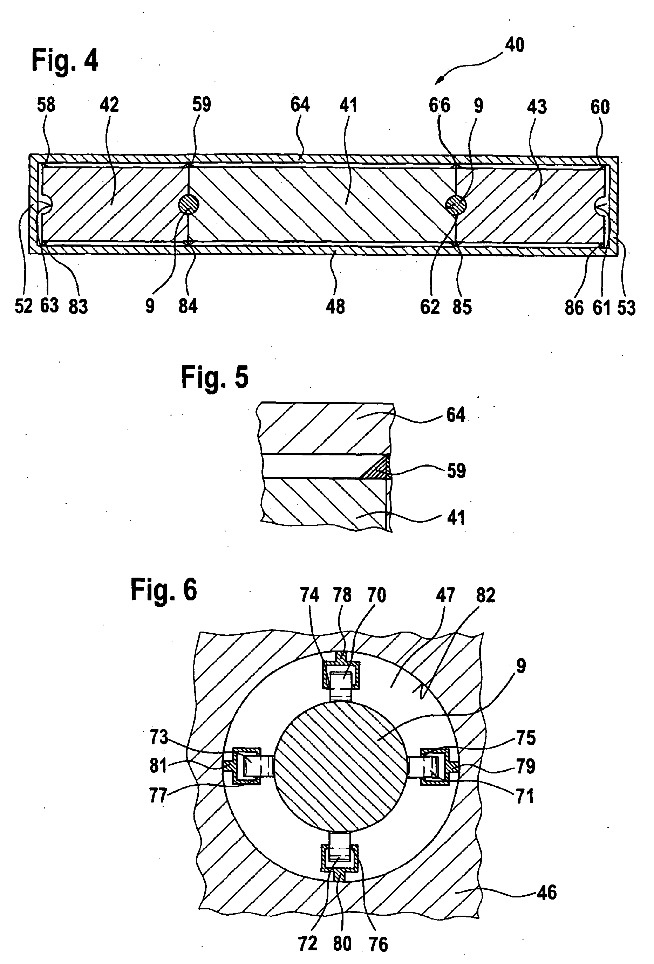

Die Fig. 4 zeigt einen Schnitt A-A (Fig. 3) durch die Schleusenräder 42, 43 und durch die Schleusentrommel 41. Man erkennt hierbei den Schlauch 9, der zwischen dem Schleusenrad 43 und der Schleusentrommel 41 bzw. zwischen der Schleusentrommel 41 und dem Schleusenrad 42 hindurchtransportiert wird. Auf den Umfängen der Schleusenräder 42 und 43 und der Schleusentrommel befinden sich hierfür halbkreisförmige Aussparungen 61, 62, 63, die dort, wo das Schleusenrad 42 und die Schleusentrommel 41 bzw. die Schleusentrommel 41 und das Schleusenrad 43 zusammenstoßen, eine kreisförmige Ausnehmung bilden, deren Durchmesser etwas größer als der Durchmesser des Schlauchs 9 ist.

Die Seitenwände 52, 53 der Vorrichtung 40 sind mit einer oberen Wand 64 verbunden. Die oberen Dichtungen 58 bis 60 und 66 der Schleusenräder 42, 43 bzw. der Schleusentrommel 41 stoßen mit ihren Spitzen gegen diese Wand 64. Die unteren Dichtungen 83 bis 86 stoßen mit ihren Spitzen gegen die untere Wand.

In der Fig. 5 ist im vergrößerten Maßstab dargestellt, wie die keilförmige Dichtung 59 der Schleusentrommel 41 mit ihrer Spitze gegen die obere Wand 64 stößt. Die Dichtungen 59, 66 sowie 84, 85 bestehen eigentlich aus zwei dreieckförmigen Dichtungen, die nebeneinander und auf verschiedenen Rädern bzw. Trommeln angeordnet sind, während die Dichtungen 58, 60 und 83, 86 nur aus einer Dichtung bestehen. Dies ist dadurch bedingt, dass die Dichtungen 59, 66, 84, 85 aus den Dichtungen der Schleusenräder 42 bzw. 43 und den Dichtungen der Schleusentrommel 41 bestehen.

Die Fig. 6 zeigt einen Schnitt B-B (Fig. 2) durch die Trennwand 46, der eine besondere Variante einer Schlauchdurchführung darstellt. Man erkennt hierbei, dass sich der Schlauch 9 auf seinem Umfang auf Rollen 70 bis 73 abstützt, die in Achsen 74 bis 77 gelagert sind. Diese Achsen 74 bis 77 sind über Verbindungselemente 78 bis 81 mit der Innenseite 82 einer Bohrung 47 verbunden, die den Bohrungen 115, 116, 117, 118 entsprechen kann. Statt vier Rollen 70 bis 73 können auch drei oder mehr als vier Rollen vorgesehen sein. Die Rollen 70 bis 73 können auch breiter sein als in der Fig. 6 dargestellt. Durch die Verwendung der Rollen 70 bis 73 wird der Schlauch 9 ohne große Reibungswiderstände geführt.

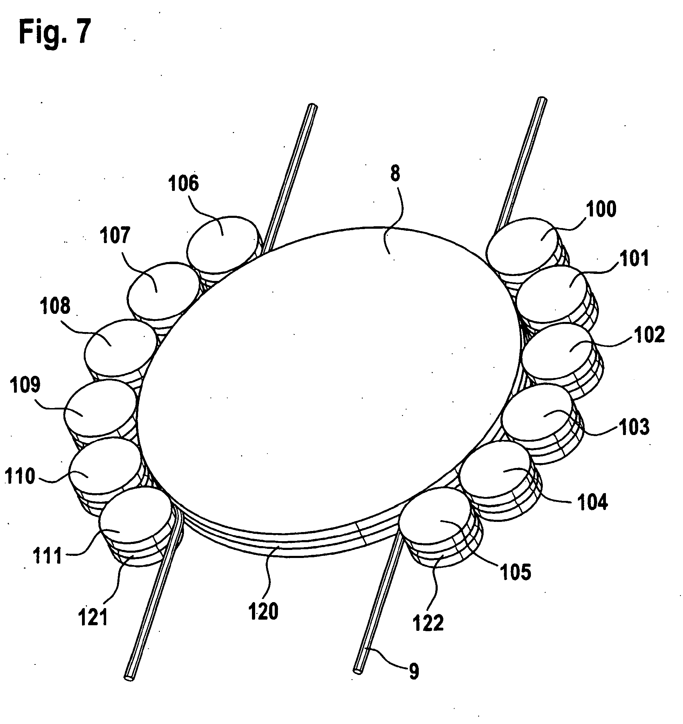

In der Fig. 7 ist die bereits in der Fig. 1 dargestellte Schleusentrommel 8 mit den Schleusenrädem 100 bis 104 bzw. 106 bis 110 noch einmal vergrößert und in perspektivischer Ansicht dargestellt. Man erkennt hierbei die umlaufende Nut 120 der Schleusentrommel 8 und die umlaufenden Nuten 121, 122 der Schleusenräder 110 bzw. 104.

Die Nuten der Schleusentrommel und der Schleusenräder sind als halbkreisförmig beschrieben worden. Es versteht sich jedoch, dass sie auch eine andere Querschnittsform haben können, beispielsweise U-förmig, z. B. wenn der Schlauch 9 eine quadratische oder rechteckige Außenseite besitzt. Halbelliptische Nuten etc. sind ebenfalls denkbar.

## Patentansprüche

1. Vorrichtung für den Transport eines Schlauchs (9) von wenigstens einer ersten Kammer (2, 54) mit einem ersten Gasdruck in eine zweite Kammer (3, 48) mit einem zweiten Gasdruck, wobei beide Kammern (2, 54; 3, 48) durch eine gemeinsame Wand (34, 46) voneinander getrennt sind, **gekennzeichnet durch**
a) zwei Durchbohrungen (47, 49) in der Wand (34, 46), deren Durchmesser wenigstens dem Durchmesser des Schlauchs (9) entspricht,
b) eine Schleusentrommel (8, 41) mit einer über ihren Umfang verlaufenden Nut (120, 62),
c) wenigstens zwei Schleusenräder (42, 43; 100 bis 111) mit einer über ihren Umfang verlaufenden Nut (121, 122; 61, 63), wobei die Schleusenräder (42, 43; 100 bis 111) mit ihrem Umfang auf dem Umfang der Schleusentrommel (8, 41) derart anliegen, dass ihre Nuten (121, 122; 61, 63) mit der Nut (120, 62) der Schleusentrommel (8, 41) einen Querschnitt bilden, der wenigstens dem Querschnitt des Schlauchs (9) entspricht.

2. Vorrichtung nach Anspruch 1, **dadurch gekennzeichnet, dass** die umlaufende Nut (120, 62) der Schleusentrommel (8, 41) und die umlaufenden Nuten (61, 63; 121, 122) der Schleusenräder (42, 43; 104, 110) halbkreisförmig ausgebildet sind.

3. Vorrichtung nach Anspruch 1, **dadurch gekennzeichnet, dass** an zwei gegenüber liegenden Stellen der Schleusentrommel (8, 41) mehrere dicht hintereinander angeordnete Schleusenräder (106 bis 111; 100 bis 105) vorgesehen sind.

4. Vorrichtung nach Anspruch 1, **dadurch gekennzeichnet, dass** die Durchbohrungen (47, 49) in der Wand (34, 46) mit Rollen (70 bis 73) versehen sind, auf denen der Schlauch (9) abrollt.

5. Vorrichtung nach Anspruch 1, **dadurch gekennzeichnet, dass** die erste Kammer eine Eingangskammer (2) und die zweite Kammer eine Transferkammer (3) ist.

6. Vorrichtung nach Anspruch 5, **dadurch gekennzeichnet, dass** sich an die Transferkammer (3) eine Beschichtungskammer (4; 48, 65) anschließt, in welcher der Schlauch (9) mit einer Monomerschicht beschichtet wird.

7. Vorrichtung nach Anspruch 6, **dadurch gekennzeichnet, dass** in der Beschichtungskammer (4) wenigstens eine Elektronenstrahlkanone (23, 24; 31, 32) zum Vernetzen der Monomerschicht vorgesehen ist.

8. Vorrichtung nach Anspruch 6, **dadurch gekennzeichnet, dass** in der Beschichtungskammer (4) wenigstens eine UV-Lichtquelle zum Vernetzen der Monomerschicht vorgesehen ist.

9. Vorrichtung nach Anspruch 6, **dadurch gekennzeichnet, dass** sich an die Beschichtungskammer (4) eine Metallisierungskammer (5) anschließt, in welcher der mit einer Monomerschicht versehene Schlauch (9) mit einer Metallschicht oder dergleichen versehen wird.

10. Vorrichtung nach Anspruch 9, **dadurch gekennzeichnet, dass** die Metallisierungskammer (5) eine Sputterkammer ist.

11. Vorrichtung nach den Ansprüchen 6 und 9, **dadurch gekennzeichnet, dass** wenigstens entweder die Beschichtungskammer (4) oder die Metallisierungskammer (5) aus zwei Beschichtungsbereichen (48, 65; 26, 28) bestehen, wobei der eine Beschichtungsbereich (48, 26) für den Vorlauf des Schlauchs (9) und der andere Beschichtungsbereich (28, 65) für den Rücklauf des Schlauchs (9) vorgesehen sind.

12. Vorrichtung nach Anspruch 5 und Anspruch 6, **dadurch gekennzeichnet, dass** in der Transferkammer (3) und in der Metallisierungskammer (5) jeweils eine Umlenktrommel (21, 27) vorgesehen ist.

13. Vorrichtung nach Anspruch 12, **dadurch gekennzeichnet, dass** die Umlenktrommeln (21, 27) gleiche Durchmesser besitzen.

14. Vorrichtung nach den Ansprüchen 1 und 12, **dadurch gekennzeichnet, dass** in der Transferkammer (3) und zwischen der Umlenktrommel (21) und der Schleusentrommel (8) zwei Umlenkrollen (20, 33) vorgesehen sind.

15. Vorrichtung nach Anspruch 1, **dadurch gekennzeichnet, dass** die Schleusentrommel (8) und die Schleusenräder (100 bis 111) von einem Gehäuse (39; 55, 56, 57) umgeben sind und auf der Außenseite dieses Gehäuses Pumpvorrichtungen vorgesehen sind.

16. Verfahren zum Beschichten eines Schlauchs, **gekennzeichnet durch** folgende Schritte:
a) der Schlauch (9) wird von einer Abwickeltrommel (7) abgewickelt und in den Zwischenraum zwischen einer Schleusentrommel (8) und wenigstens einem Schleusenrad (42) gegeben,
b) der Schlauch (9) wird in eine Beschichtungskammer (4) transportiert, wo er mit einer Polymerschicht versehen wird,
c) der Schlauch (9) wird in eine Metallisierungskammer (5) transportiert, wo er mit einer Metallschicht oder dergleichen versehen wird,
d) der Schlauch wird in den Zwischenraum zwischen der Schleusentrommel (8) und wenigstens einem Schleusenrad (42) gegeben und auf eine Aufwickelrolle (6) gewickelt.

17. Verfahren zum Beschichten eines Schlauchs, **gekennzeichnet durch** folgende Schritte:
a) der Schlauch (9) wird von einer Abwickeltrommel (7) abgewickelt und in den Zwischenraum zwischen einer Schleusentrommel (8) und wenigstens einem Schleusenrad (42) gegeben,
b) der Schlauch (9) wird in eine Beschichtungskammer (4) transportiert, wo er mit einer ersten Polymerschicht versehen wird,
c) der Schlauch (9) wird in eine Metallisierungskammer (5) transportiert, wo er mit einer ersten Metallschicht versehen wird,
d) der Schlauch (9) wird um 180 Grad umgelenkt und in der Metallisierungskammer (5) mit einer zweiten Metallschicht versehen,
e) der Schlauch (9) wird in die Beschichtungskammer (4) transportiert und dort mit einer zweiten Polymerbeschichtung versehen,
f) der Schlauch wird in den Zwischenraum zwischen der Schleusentrommel (8) und wenigstens einem Schleusenrad (42) gegeben und auf eine Aufwickelrolle (6) gewickelt.

18. Verfahren nach Anspruch 16, **dadurch gekennzeichnet, dass** der Schlauch (9) vor dem Durchlaufen der Beschichtungskammer (4) eine Transferkammer (3) durchläuft, wo er ausgerichtet wird.

## Claims

1. A device for transporting a tube (9) from at least one first chamber (2, 54) having a first gas pressure into a second chamber (3, 48) having a second gas pressure, both chambers (2, 54; 3, 48) being separated from each other by a shared wall (34, 46), **characterised by**
a) two through holes (47, 49) provided in the wall (34, 46) the diameter of which corresponds at least to the diameter of the tube (9),
b) an airlock drum (8, 41) having a groove (120, 62) extending about its circumference,
c) at least two airlock wheels (42, 43; 100 to 111) each having a groove (121, 122; 61, 63) extending about its circumference, said airlock wheels (42, 43; 100 to 111) being applied, with their circumference, to the circumference of the airlock drum (8, 41) in such a manner that their respective grooves (121, 122; 61, 63) cooperate with the groove (120, 62) of the airlock drum (8, 41) to form a diameter which corresponds at least to the diameter of the tube (9).

2. The device as claimed in claim 1, **characterised in that** the circumferential groove (120, 62) of the airlock drum (8, 41) and the circumferential grooves (61, 63; 121, 122) of the airlock wheels (42, 43; 104, 110) are shaped in a semi-circular form.

3. The device as claimed in claim 1, **characterised in that** a plurality of airlock wheels (106 to 111; 100 to 105) arranged in close succession with respect to each other are provided at two opposing locations of the airlock drum (8, 41).

4. The device as claimed in claim 1, **characterised in that** the through holes (47, 49) formed in the wall (34, 46) are provided with rollers (70 to 73) on which the tube (9) runs as it advances.

5. The device as claimed in claim 1, **characterised in that** the first chamber is an entrance chamber (2) and the second chamber is a transfer chamber (3).

6. The device as claimed in claim 5, **characterised in that** the transfer chamber (3) is followed by a coating chamber (4; 48, 65) in which the tube (9) is coated with a monomer layer.

7. The device as claimed in claim 6, **characterised in that** the coating chamber (4) is provided with at least one electron beam gun (23, 24; 31, 32) for cross-linking the monomer layer.

8. The device as claimed in claim 6, **characterised in that** the coating chamber (4) is provided with at least one UV light source for cross-linking the monomer layer.

9. The device as claimed in claim 6, **characterised in that** the coating chamber (4) is followed by a metallisation chamber (5) in which the tube (9), after having received a monomer layer, is provided with a metal layer or the like.

10. The device as claimed in claim 9, **characterised in that** the metallisation chamber (5) is a sputtering chamber.

11. The device as claimed in claims 6 and 9, **characterised in that** at least one of the coating chamber (4) and the metallisation chamber (5) consists of two coating zones (48, 65; 26, 28), one coating zone (48, 26) being provided for the feed motion of the tube (9) and the other coating zone (28, 65) being provided for the return motion of the tube (9).

12. The device as claimed in claim 5 and claim 6, **characterised in that** the transfer chamber (3) and the metallisation chamber (5) are each provided with a deflection drum (21, 27).

13. The device as claimed in claim 12, **characterised in that** the deflection drums (21, 27) have identical diameters.

14. The device as claimed in claims 1 and 12, **characterised in that** within the transfer chamber (3) two deflection rollers (20, 33) are provided between the deflection drum (21) and the airlock drum (8).

15. The device as claimed in claim 1, **characterised in that** the airlock drum (8) and the airlock wheels (100 to 111) are surrounded by a housing (39; 55, 56, 57) and pumping devices are provided on the outer side of this housing.

16. A method for coating a tube, **characterised by** the steps of:
a) unwinding the tube (9) from a take-off drum (7) and inserting it into the interspace between an airlock drum (8) and at least one airlock wheel (42),
b) transporting the tube (9) into a coating chamber (4) where it is provided with a polymer layer,
c) transporting the tube (9) into a metallisation chamber (5) where it is provided with a metal layer or the like,
d) inserting the tube (9) into the interspace between the airlock drum (8) and at least one airlock wheel (42) and winding it onto a take-up roller (6).

17. A method for coating a tube **characterised by** the steps of:
a) unwinding the tube (9) from a take-off drum (7) and inserting it into the interspace between an airlock drum (8) and at least one airlock wheel (42),
b) transporting the tube (9) into a coating chamber (4) where it is provided with a first polymer layer,
c) transporting the tube (9) into a metallisation chamber (5) where it is provided with a first metal layer,
d) deflecting the tube (9) by 180 degrees and providing it, in the metallisation chamber (5), with a second metal layer,
e) transporting the tube (9) into the coating chamber (4) and providing it therein with a second polymer layer,
f) inserting the tube into the interspace between the airlock drum (8) and at least one airlock wheel (42) and winding it onto a take-up roller (6).

18. The method as claimed in claim 16, **characterised in that** prior to its passage through the coating chamber (4), the tube (9) passes through a transfer chamber (3) where it is aligned.

## Revendications

1. Dispositif permettant de transporter un tuyau (9) depuis au moins une première chambre (2, 54) présentant une première pression de gaz jusque dans une deuxième chambre (3, 48) présentant une deuxième pression de gaz, les deux chambres (2, 54; 3, 48) étant séparées l'une de l'autre par une paroi commune (34, 46), **caractérisé par**
a) deux perforations (47, 49) situées dans la paroi (34, 46) et dont le diamètre correspond au moins au diamètre du tuyau (9),
b) un tambour de sas (8, 41) pourvu d'une rainure (120, 62) s'étendant sur sa circonférence,
c) au moins deux roues de sas (42, 43; 100 à 111) pourvues d'une rainure (121, 122; 61, 63) s'étendant sur leur circonférence, les roues de sas (42, 43; 100 à 111) reposant, avec leur circonférence, sur la circonférence du tambour de sas (8, 41) de manière telle que leurs rainures (121, 122; 61, 63) forment, avec la rainure (120, 62) du tambour de sas (8, 41), une section qui correspond au moins à la section du tuyau (9).

2. Dispositif selon la revendication 1, **caractérisé en ce que** la rainure circonférentielle (120, 62) du tambour de sas (8, 41) et les rainures circonférentielles (61, 63; 121, 122) des roues de sas (42, 43; 104, 110) sont réalisées en forme de demi-cercle.

3. Dispositif selon la revendication 1, **caractérisé en ce qu'**il est prévu en deux endroits opposés du tambour de sas (8, 41) plusieurs roues de sas (106 à 111; 100 à 105) disposées étroitement les unes derrière les autres.

4. Dispositif selon la revendication 1, **caractérisé en ce que** les perforations (47, 49) situées dans la paroi (34, 46) sont pourvues de rouleaux (70 à 73) sur lesquels est transporté le tuyau (9).

5. Dispositif selon la revendication 1, **caractérisé en ce que** la première chambre est une chambre d'entrée (2) et la deuxième chambre est une chambre de transfert (3).

6. Dispositif selon la revendication 5, **caractérisé en ce que** la chambre de transfert (3) est suivie par une chambre de recouvrement (4; 48, 65), dans laquelle le tuyau (9) est recouvert d'une couche de monomère.

7. Dispositif selon la revendication 6, **caractérisé en ce que** dans la chambre de recouvrement (4) est prévu au moins un canon à électrons (23, 24; 31, 32) en vue de réticuler la couche de monomère.

8. Dispositif selon la revendication 6, **caractérisé en ce que** dans la chambre de recouvrement (4) est prévue au moins une source de lumière UV en vue de réticuler la couche de monomère.

9. Dispositif selon la revendication 6, **caractérisé en ce que** la chambre de recouvrement (4) est suivie par une chambre de métallisation (5), dans laquelle le tuyau (9) pourvu d'une couche de monomère est pourvu d'une couche métallique ou d'une autre couche semblable.

10. Dispositif selon la revendication 9, **caractérisé en ce que** la chambre de métallisation (5) est une chambre de pulvérisation cathodique.

11. Dispositif selon les revendications 6 et 9, **caractérisé en ce qu'**au moins soit la chambre de recouvrement (4), soit la chambre de métallisation (5) se compose de deux zones de recouvrement (48, 65; 26, 28), l'une des zones de recouvrement (48, 26) étant prévue pour l'avance du tuyau (9) et l'autre zone de recouvrement (28, 65) pour le mouvement de retour du tuyau (9).

12. Dispositif selon la revendication 5 et la revendication 6, **caractérisé en ce qu'**un tambour de déviation (21, 27) est prévu respectivement dans la chambre de transfert (3) et dans la chambre de métallisation (5).

13. Dispositif selon la revendication 12, **caractérisé en ce que** les tambours de déviation (21, 27) possèdent le même diamètre.

14. Dispositif selon les revendications 1 et 12, **caractérisé en ce que** dans la chambre de transfert (3) deux poulies de déviation (20, 33) sont prévues entre le tambour de déviation (21) et le tambour de sas (8).

15. Dispositif selon la revendication 1, **caractérisé en ce que** le tambour de sas (8) et les roues de sas (100 à 111) sont entourés par un boîtier (39; 55, 56, 57), et **en ce que** sur la face extérieure de ce boîtier sont prévus des dispositifs de pompage.

16. Procédé de recouvrement d'un tuyau, **caractérisé par** les étapes suivantes:
a) le tuyau (9) est déroulé d'un tambour de déroulement (7) et est introduit dans l'espace situé entre un tambour de sas (8) et au moins une roue de sas (42),
b) le tuyau (9) est transporté dans une chambre de recouvrement (4) où il est pourvu d'une couche de polymère,
c) le tuyau (9) est transporté dans une chambre de métallisation (5) où il est pourvu d'une couche métallique ou d'une autre couche semblable,
d) le tuyau est introduit dans l'espace situé entre le tambour de sas (8) et au moins une roue de sas (42) et est enroulé sur une poulie d'enroulement (6).

17. Procédé de recouvrement d'un tuyau, **caractérisé par** les étapes suivantes:
a) le tuyau (9) est déroulé d'un tambour de déroulement (7) et est introduit dans l'espace situé entre un tambour de sas (8) et au moins une roue de sas (42),
b) le tuyau (9) est transporté dans une chambre de recouvrement (4) où il est pourvu d'une première couche de polymère,
c) le tuyau (9) est transporté dans une chambre de métallisation (5) où il est pourvu d'une première couche métallique,
d) le tuyau (9) est dévié de 180 degrés et est pourvu, dans la chambre de métallisation (5), d'une deuxième couche métallique,
e) le tuyau (9) est transporté dans la chambre de recouvrement (4) où il est pourvu d'une deuxième couche de polymère,
f) le tuyau est introduit dans l'espace situé entre le tambour de sas (8) et au moins une roue de sas (42) et est enroulé sur une poulie d'enroulement (6).

18. Procédé selon la revendication 16, **caractérisé en ce que** le tuyau (9) passe, avant de traverser la chambre de recouvrement (4), par une chambre de transfert (3) où il est aligné.
